# EUROPEAN PATENT APPLICATION

(11) **EP 2 937 998 A1**
(43) Date of publication of application: **28.10.2015**
(21) Application number: 14166048.0
(22) Date of filing: 25.04.2014
(51) Int. Cl.: H03K 17/955, H01H 3/02

(54) **Providing capacitive sensing to a push button**

(71) Applicant: Home Control Singapore Pte. Ltd., Singapore 319762 (SG)
(72) Inventor: Sim, Mark, 5600 AE Eindhoven (NL); Chen, Koh Siang, 5600 AE Eindhoven (NL)
(74) Representative: Ferreccio, Rinaldo

(57) **Abstract**

An assembly is provided for providing capacitive sensing to a push button. The assembly comprises a printed circuit board (120) having a component side (120C) and a button side (120B). The component side comprises a conductive layer for surface mounting of electronic components, while the button side comprises a push detection element (140) for use in push detection of the push button (040). A sensor controller is mounted on the component side. A capacitive sensor comprises a conductive plate (160) having at least two connectors protruding and angling away from the conductive plate. The printed circuit board (120) comprises at least two through-holes (122, 124). The conductive plate (160) is arranged on the button side (120B), with the at least two connectors extending through respective ones of the at least two through-holes to the component side (120C) for establishing an electrical connection to the sensor controller. This assembly enables capacitive sensing without needing a conductive layer on the button side. Advantageously, a double-sided PCB is not needed. Rather, a single-sided PCB suffices.

## Description

### FIELD OF THE INVENTION

The invention relates to an assembly for providing capacitive sensing to a push button. The invention further relates to a device, such as a remote control, comprising a push button and the assembly, and to a method of manufacturing the assembly.

### BACKGROUND OF THE INVENTION

It is desirable to provide capacitive sensing to a push button. For example, when provided to a push button of a remote control, this may enable a user to provide touch-based commands by performing touch actions on the push button's surface.

It is known to provide capacitive sensing by providing a capacitive sensor pad on a printed circuit board (PCB) to allow a sensor controller to detect the changes in capacitance when a finger approaches the capacitive sensor pad. Such design is described by http://www.planetanalog.com/document.asp?doc_id=527410 (consulted on January 15^{th} 2014). Here, a PCB is described in which a sensor pad is formed on the top side of the PCB. The sensor pad is isolated from the ground plane of the PCB by a uniform gap of 0.5mm. A via in the PCB connects the sensor pad to the trace on the bottom side of the board.

US 2010/0053087 A1 describes a touch sensor which is formed in a top conductive layer of a PCB. The top conductive layer may be of copper. It is said that interdigitated fingers, concentric spirals, or other patterns may be formed in the top conductive layer, and that the dielectric layer above the top conductive layer is thin enough to permit these patterns to serve as capacitive sensors in an array. Accordingly, the patterns sense the presence of an object contacting the dielectric layer using a change in the capacitance of the patterns dependent on the proximity of the object to the patterns.

### SUMMARY OF THE INVENTION

Disadvantageously, US 2010/0053087 Al uses a double-sided PCB, i.e., comprising top and bottom conductive layers on opposing surfaces of the PCB. A double-sided PCB requires significantly more conductive material, e.g., copper, than a single-sided PCB, i.e., a PCB comprising a conductive layer only on one side. In addition, the PCB has to be manufactured to comprise conductive layers on both of the PCB's surfaces.

It would be advantageous to obtain an assembly for providing capacitive sensing to a push button, which does not require use of a double-sided PCB.

To better address this concern, a first aspect of the invention provides an assembly for providing capacitive sensing to a push button, comprising:
- a printed circuit board comprising a component side and a button side, the component side comprising a conductive layer for surface mounting of electronic components, the button side comprising a push detection element for use in push detection of the push button;
- a sensor controller mounted on the component side;
- a capacitive sensor electrically connected to the sensor controller to establish the capacitive sensing in a proximity of the capacitive sensor;
   wherein:
- the capacitive sensor comprises a conductive plate having at least two connectors protruding and angling away from the conductive plate;
- the printed circuit board comprises at least two through-holes; and
- the conductive plate is arranged on the button side, with the at least two connectors extending through respective ones of the at least two through-holes to the component side for establishing said electrical connection to the sensor controller.

In a further aspect of the invention, a device is provided comprising a push button and the assembly. The device may be a remote control.

In a further aspect of the invention, a method of manufacturing an assembly is provided, the assembly providing capacitive sensing to a push button, the method comprising:
- providing a printed circuit board comprising a component side and a button side, the component side comprising a conductive layer for surface mounting of electronic components, the button side comprising a push detection element for use in push detection of the push button, the printed circuit board comprising at least two through-holes;
- mounting a sensor controller on the component side;
- providing a capacitive sensor electrically connected to the sensor controller to establish the capacitive sensing in a proximity of the capacitive sensor, wherein the capacitive sensor comprises a conductive plate having at least two connectors protruding and angling away from the conductive plate;
- arranging the conductive plate on the button side, with the at least two connectors extending through respective ones of the at least two through-holes to the component side for establishing said electrical connection to the sensor controller.

The assembly comprises a printed circuit board (PCB) which has, on one of its sides, a conductive layer for surface mounting of electronic components. This side is referred to as component side. The other, opposing side of the PCB comprises a push detection element for use in push detection of the push button. Examples of push detection elements include micro switches, conductors which are shorted upon depressing of the push button, etc. Accordingly, when the assembly is mounted or integrated into a device, this other side faces the push button and is thus referred to as button side. It is noted that, when mounted in the device, the button side may also be referred to as front side in that the buttons are often positioned frontally on a device, i.e., facing a user. The component side may also be referred to as back side in that it may face away from the user when mounted in the device.

The assembly further comprises a sensor controller which is mounted on the component side. In addition, a capacitive sensor is provided for, when electrically connected to the sensor controller, provides the capacitive sensing in a neighborhood of the capacitive sensor. It is noted that the size of the neighborhood, i.e., the range of the capacitive sensing, is determined by various design parameters of the capacitive sensor and the sensor controller, such as the size of the capacitive sensor, the sensitivity of the sensor controller, etc. The design parameters may be selected to provide capacitive sensing on the surface of the push button, or part of said surface. The sensor controller may be of a known type, with the capacitive plate representing an electrode connected to an internal measurement circuit of the sensor controller. Such types of sensor controllers are also commonly referred to as capacitive touch sensor controllers, and known per se, e.g. from the field of touch sensing.

In the assembly as claimed, the capacitive sensor comprises an electrically conductive plate which has at least two connectors. The connectors extend and angle away from the conductive plate, in that they protrude from a virtual plane running through and along the conductive plate. For example, the connectors may angle away at approximately 90 degrees, thereby effectively forming "legs" of the electrically conductive plate.

The printed circuit board comprises at least two through-holes which pass through the PCB, i.e., from the button side to the component side. The connectors of the conductive plate align with the through-holes of the PCB, in that, when the conductive plate is arranged on the button side, the at least two connectors extend through respective ones of the at least two through-holes to the component side. Accordingly, an electrical connection can be established with the sensor controller despite being the capacitive sensor and the sensor controller each being arranged on opposite sides of the PCB.

The inventors have recognized that at least one side of a PCB needs to be provided with a conductive layer for surface mounting of electronic components. However, due to space requirements, it is frequently not possible to, on this same side of the PCB, also provide the push detection element for use in push detection of the push button as well as the capacitive sensor for the capacitive sensing. Therefore, the push detection element and the capacitive sensor are to be provided on the opposite side of the PCB, i.e., on a button side. To provide, in such a scenario, a capacitive sensor of the known type here, the button side also needs to be provided with a conductive layer, namely to allow the capacitive sensor to be formed as a pattern in the conductive layer. Disadvantageously, such a double-sided PCB requires a large amount of conductive material and is thus costly to manufacture.

By providing the capacitive sensor in the form of a separate conductive plate which comprises protruding and angling-away connectors, e.g., "legs", it is not needed to provide a conductive layer on the button side of the PCB. Rather, it suffices to provide the PCB with through-holes which are aligned with the connectors of the conductive plate. As such, the conductive plate can be electrically connected to the sensor controller on the opposite side of the PCB. Advantageously, a single-sided PCB, i.e., having a conductive layer on only one side, suffices. A more costly double-sided PCB is thus not needed.

Optionally, the conductive plate is at least in part affixed to the printed circuit board by the at least two connectors being soldered to the component side. By soldering the connectors to the component side of printed circuit board, the connectors and thereby the entire conductive plate is affixed to the printed circuit board. Advantageously, it is not needed to separately affix the conductive plate to the button side of the printed circuit board, e.g., by gluing or by soldering the conductive plate to the button side. Advantageously, the soldering may additionally provide the electrical connection to the sensor controller.

Optionally, the conductive plate has a circular shape. A circular shape is well suited for use as a capacitive sensor. In particular, the circular shape well matches the shape of typical push buttons in that such push buttons typically have a circular circumference.

Optionally, the conductive plate comprises a cut-out for, when arranged on the button side, accommodating the push detection element. By accommodating the push detection element within a cut-out of the conductive plate, the push detection element and the conductive plate can be brought simultaneously into close vicinity of the push button.

Optionally, the conductive plate is a stainless steel plate, or a phosphor bronze plate with silver plating. Although in general any metal may be used, it may be preferable to use a plate which is resistant to rust and is capable of being soldered. A stainless steel plate, or a phosphor bronze plate with silver plating, are well suited for this purpose.

Optionally, the printed circuit board is a single-sided printed circuit board. Thus, only the component side is provided with a conductive layer.

Optionally, the push detection element comprises a carbon print. A carbon print may be obtained by providing a carbon layer on the button side. Accordingly, the printed circuit board may be a single layer printed circuit board with a carbon layer on the non-copper, i.e., button side, with a carbon print being obtained from the carbon layer.

In summary, a printed circuit board is provided which comprises a component side and a button side. The component side comprises a conductive layer for surface mounting of electronic components. The button side comprises a push detection element for use in push detection of a push button. A sensor controller is mounted on the component side. A capacitive sensor comprises a conductive plate having at least two connectors protruding and angling away from the conductive plate. The printed circuit board comprises at least two through-holes. The conductive plate is arranged on the button side, with the at least two connectors extending through respective ones of the at least two through-holes to the component side for establishing an electrical connection to the sensor controller. This assembly enables capacitive sensing without needing a conductive layer on the button side. Thus, a double-sided PCB is not needed. Rather, a single-sided PCB suffices.

It will be appreciated by those skilled in the art that two or more of the above-mentioned embodiments, implementations, and/or aspects of the invention may be combined in any way deemed useful.

Modifications and variations of the method or the device, which correspond to the described modifications and variations of the assembly, can be carried out by a person skilled in the art on the basis of the present description.

The invention is defined in the independent claims. Advantageous embodiments are defined in the dependent claims.

### BRIEF DESCRIPTION OF THE DRAWINGS

These and other aspects of the invention are apparent from and will be elucidated with reference to the embodiments described hereinafter. In the drawings,
Fig. 1 shows an exploded view of a device comprising a push button and an assembly for providing capacitive sensing to the push button, the assembly comprising a capacitive sensor in the form of a conductive plate having protruding connectors;
Fig. 2 shows a front side view of the conductive plate;
Fig. 3 shows a cross-section along the plane III-III of Fig 2 which shows the conductive plate's connectors protruding and angling away from the conductive plate;
Fig. 4 shows a cross-section along the plane IV-IV of Fig 2;
Fig. 5 shows a front side view of the device;
Fig. 6 shows a cross-section along the plane VI-VI of Fig. 5;
Fig. 7 shows a cut-out view of the section VII of Fig. 6; and
Fig. 8 shows a method for manufacturing the assembly.

### List of reference numerals:

- 010: device
- 020: housing
- 040: push button
- 060: front plate
- 100: assembly
- 120: printed circuit board
- 120B: button side of printed circuit board
- 120B: component side of printed circuit board
- 122: first through-hole through printed circuit board
- 124: second through-hole of printed circuit board
- 140: push detection element
- 160: conductive plate
- 162: first protruding connector of conductive plate
- 164: second protruding connector of conductive plate
- 166: central cut-out of conductive plate
- 210: providing a printed circuit board
- 220: mounting a sensor controller
- 230: providing a capacitive sensor
- 240: arranging the conductive plate on the button side
- 250: soldering the connectors to the component side

### DETAILED DESCRIPTION OF EMBODIMENTS

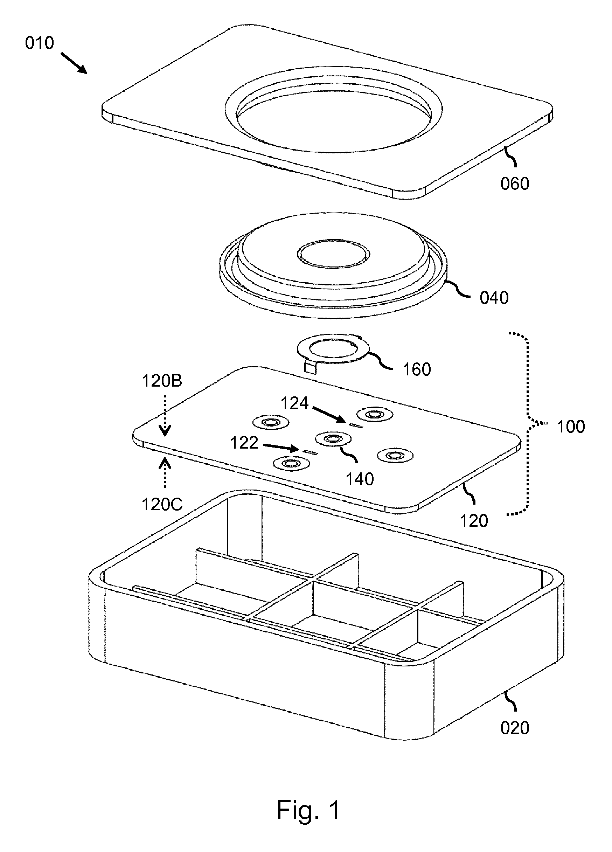

Fig. 1 shows an exploded view of a device 010. The device 010 comprises a housing 020 for housing internal parts. The internal parts include a printed circuit board 120. The printed circuit board 120 comprises a component side 120C and a button side 120B. The component side 120C comprises a conductive layer for surface mounting of electronic components. The button side 120B comprises a push detection element 140 for use in push detection of a push button 040. The device 010 is shown to comprise the push button 040. It is noted that another term for 'push' is 'press'. Another term for 'button' is 'key'. During manufacturing or assembly of the device 010, the push button is mounted in the housing at the button side 120B of the printed circuit board so that actuation of the push button 040 activates the push detection element 140. For that purpose, the front plate 060, which functions as a top cover of the housing 020, comprises a cut-out so as to allow the push button to be externally operable by a user. It is noted that such combinations of push buttons and push detection elements are known per se, e.g., from the field of remote controls.

The device 010 is further shown to comprise a capacitive sensor 160. The capacitive sensor 160 is provided which is electrically connected to a sensor controller. Together, the sensor controller and the capacitive sensor 160 provide capacitive sensing in a proximity of the capacitive sensor. The sensor controller is mounted on the component side 120C (not explicitly shown in Fig. 1). In order to establish said electrical connection to the sensor controller, the capacitive sensor is formed by a conductive plate 160 comprising two connectors protruding and angling away from the conductive plate at opposite sides of the conductive plate. The printed circuit board 120 comprises two through-holes 122, 124. As can be seen in Fig. 1, the conductive plate 160 is arranged on the button side 120B so that the two connectors extend through respective ones of the through-holes 122, 124 when the device 010 is assembled. As such, the printed circuit board 120, the sensor controller and the conductive plate 160 establish an assembly which provides capacitive sensing.

The device may be a remote control. Accordingly, the device may comprise a transmitter such as radiofrequency (RF) or infrared (IR) transmitter. However, this is not a limitation, in that the device may take any suitable form other than that shown in Fig. 1. In particular, the device may be any type of device comprising a push button. Examples of such devices vary from mobile phones, tablet devices, etc., to microwave ovens, etc..

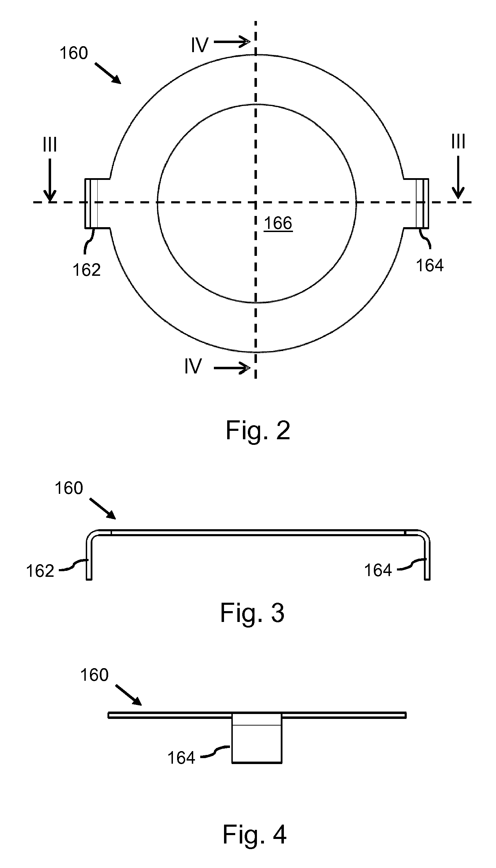

Fig. 2 shows a front side view of the conductive plate 160 which functions as a capacitive sensor. It can be seen that the conductive plate 160 has a circular shape and comprises a cut-out 166. The cut-out 166 is dimensioned for accommodating the push detection element, so that the push button 040 can actuate the push detection element through the cut-out 166 when the device 010 is assembled. Fig. 2 further shows two connectors 162, 164 protruding away from the conductive plate 160 from opposite sides of the conductive plate. It can be seen in Figs. 3 and 4 that the connectors 162, 164 not only protrude from the conductive plate 160, but also angle away from the virtual plane running through and along the conductive plate 160. Fig. 3 shows a cross-section of the conductive plate 160 along the plane III-III of Fig. 2, and Fig. 4 shows another, orthogonal cross-section of the conductive plate 160 along the plane IV-IV of Fig. 2. It can be seen that the connectors 162, 164 effectively form "legs" of the conductive plate 160. However, this is not a limitation, in that the connectors may also take any other suitable form other than that shown in Figs. 2-4. In particular, the angling-away may be achieved only during assembly when the connectors are subjected to a mechanical force. Accordingly, before assembly, the connectors may simply protrude from the conductive plate without angling away. Also, the angling away may be at any suitable angle, and in particular, may take place at a non-constant angle.

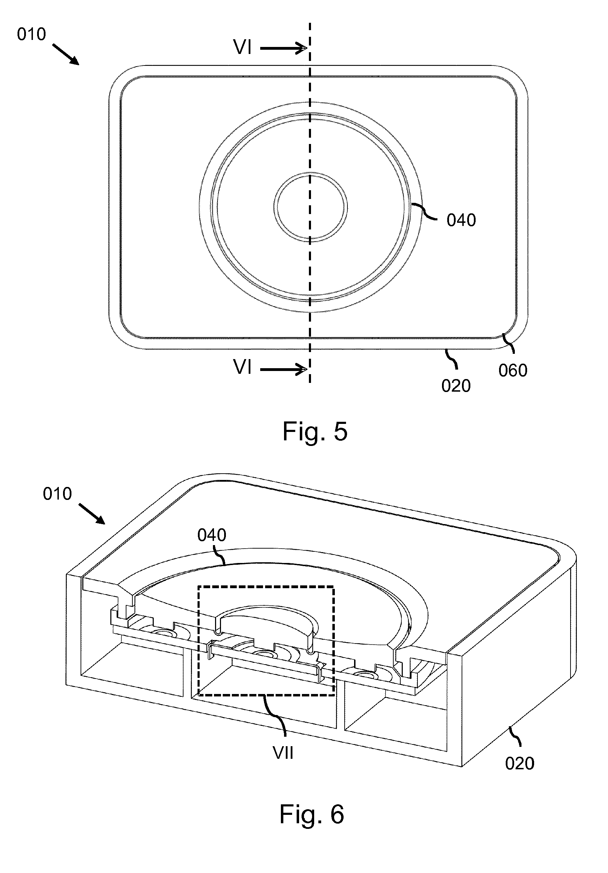

Fig. 5 shows a front side view of the device 010 showing a surface of the push button 040, the front plate 060 and the housing 020. This front side view is typically a user facing view of the device 010 in that the front side shown in Fig. 5 may be typically oriented towards the user when the user operates the device 010. However, this is not a limitation, in that the surface of the push button 040 may also face away from the user during operation. The push button 040 may therefore be a 'hidden' push button in that it may require the user to feel rather than see the push button when operating the device 010. For that purpose, the push button 040 may be physically delineated from the front plate, e.g., by slightly protruding from or being sunken into the front plate, thereby providing a user with tactile feedback.

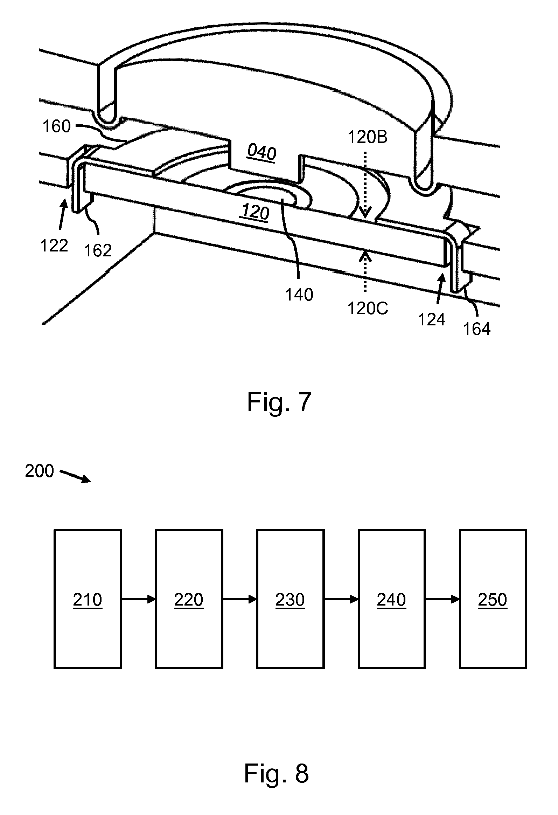

Fig. 6 shows a cross-section of the device along the plane VI-VI of Fig. 5. Compared to Fig. 1, Fig. 6 shows a view of the device when assembled. Fig. 7 shows a cut-out view of the section VII of Fig. 6, showing more detail. It can be seen that, when assembled, the push button 040 is arranged such that a downward facing protrusion of the push button 040 is oriented towards the push detection element 140. Moreover, it can be seen that the conductive plate 160 is arranged on the printed circuit board 120, namely on the button side 120B, such that the connectors 162, 164 protrude through respective ones of the through holes 122, 124 of the printed circuit board 120. Moreover, although not shown explicitly in Fig. 7, the conductive plate 160 may be at least in part affixed to the printed circuit board 120 and thus the assembly by the at least two connectors 162, 164 being soldered to the component side 120C. With such soldering, also the electrical connection to the sensor controller on the component side 120C (not explicitly shown in Fig. 7) may be established. Alternatively, the conductive plate 160 may be affixed in a different manner to the printed circuit board 120, e.g., by gluing or using another type of soldering, etc.. It is therefore not needed for the soldering to provide the affixing or the electrical connection.

It is noted that, by way of example, the push button 040 shown in Figs. 1-7 is a five-way push-button, it that it enables five separate push actions. For that purpose, the printed circuit board is provided with five separate push detection elements, as can be seen in Fig. 1. As such, the push button 040 may function as a directional pad, namely by allowing up, down, left, right commands to be provided by the user pressing the respective sides of the push button 040. Moreover, the push button 040 may allow a selection command to be provided, namely by the user pressing the center of the push button 040. Effectively, the push button 040 of Figs. 1-7 comprises five separate sub-buttons. It is noted that the assembly may provide capacitive sensing to the entire surface of the push button 040 as formed by the five separate sub-buttons, or only to a part of the surface, e.g., the central sub-button.

It is noted that, in general, the conductive plate 160 may be a stainless steel plate, or a phosphor bronze plate with silver plating. Alternatively, the conductive plate 160 may be made from another metal or alloy, preferably but not necessarily one which is resistant to rust and capable of being soldered. Moreover, the printed circuit board 120 may be a single-sided printed circuit board in which the button side 120B omits a conductive layer. Accordingly, only the component side may be provided with copper traces for interconnecting components. The button side 120B may rather be provided with a carbon layer. The carbon layer may be printed onto the surface of button side 120B, for example, using a silkscreen method which is known per se. Accordingly, the push detection element 140 may be provided in the form of a carbon print in or on the carbon layer. The printed carbon is a conductor. By providing the underside of the push button also with a layer of carbon print, a carbon circuit may be formed which is 'shorted' by the push button being depressed and therefore the carbon print of the push button being brought in contact with the carbon print on the PCB. Such a 'short' may be detected by a micro-controller.

Fig. 8 shows a method 200 for manufacturing an assembly for providing capacitive sensing to a push button. The method 200 may be used to manufacture the assembly as shown in Figs. 1-7. However, this is not a limitation, in that the method 200 may be used to manufacture an assembly other than that of Figs. 1-7. In general, the method 200 may be performed as part of manufacturing a device comprising the assembly.

The method 200 comprises, in an operation titled "PROVIDING PRINTED CIRCUIT BOARD", providing 210 a printed circuit board comprising a component side and a button side, the component side comprising a conductive layer for surface mounting of electronic components, the button side comprising a push detection element for use in push detection of the push button, the printed circuit board comprising at least two through-holes. The method 200 further comprises, in an operation titled "MOUNTING SENSOR CONTROLLER", mounting 220 a sensor controller on the component side. The method 200 further comprises, in an operation titled "PROVIDING CAPACITIVE SENSOR", providing 230 a capacitive sensor electrically connected to the sensor controller to establish the capacitive sensing in a proximity of the capacitive sensor, wherein the capacitive sensor is formed by a conductive plate comprising at least two connectors protruding and angling away from the conductive plate. The method 200 further comprises, in an operation titled "ARRANGING CONDUCTIVE PLATE ON BUTTON SIDE", arranging 240 the conductive plate on the button side, with the at least two connectors extending through respective ones of the at least two through-holes to the component side for establishing said electrical connection to the sensor controller.

It is noted that the operations of the method 200 may be performed in any suitable order. In particular, the operation of mounting 220 the sensor controller may be performed in parallel, before or after the providing 230 of the conductive plate and the arranging 240 of the conductive plate on the button side of the printed circuit board.

Fig. 8 further shows an optional aspect of the method 200, in that the method 200 may further comprise, in an operation titled "SOLDERING CONNECTORS TO COMPONENT SIDE", soldering 250 the at least two connectors to the component side for at least in part affixing the conductive plate to the printed circuit board. It is noted that the conductive plate may also be affixed in another manner to the printed circuit board.

It is noted that the assembly as claimed may be advantageously used to provide a remote control with a combined push/touch function key or button (henceforth, the term 'key' is used, but may equally be understood as referring to 'button'). The function key may be a physical key, i.e., non-virtual. In particular, the function key may have a raised profile on the remote control in that it normally, in a non-depressed state, protrudes from the housing of the remote control. The function key may be of a 'push-type' in that it is downward depressible by the user, i.e., towards the housing. Such depressing of the function key by the user may be sensed by a key push-detector, which may then generates a key press signal causing a control circuit of the remote control to perform a primary control function. Typically, such control functions cause the remote control to a send a wireless control signal, such as an infrared (IR) or radio frequency (RF) signal, to the remotely controllable device which activates, modifies or otherwise controls a device function of the device.

The remote control may comprise the assembly as claimed to sense a touch action of the user performed on the key surface of the function key. Here, the term key surface refers to the frontal surface of the key to which the user's finger is to be applied for depressing the function key. Accordingly, the capacitive sensor may sense when the user touches or hovers over the key surface, i.e., with his/her finger. Having sensed the touch action, the capacitive sensor may generate a key touch signal causing the control circuit to effect a secondary control function. An example may be that, upon touching or hovering over the key surface, the remotely controllable device may show a user interface, and upon depressing the function key, a selection may be made in the user interface.

As such, a remote control may be provided which comprises a physical function key which provides tactile feedback to the user, namely by the function key protruding from the housing in a non-depressed state and by being physically depressible and thus providing tactile feedback upon actuation. However, contrary to known remote controls with function keys of the above type, the remote control may enable the user to additionally perform a touch action on the key's surface which effects a secondary control function. Hence, the function key, which may have the visual and tactile appearance of a conventional remote control key, enables a user to effect two different control functions, namely by performing the pressing action or the touch action. Here, the primary control function and the secondary control function may provide different types of control of a device function of a remote controllable device. Hence, the primary control function and the secondary control function may control a particular device function, such as volume, playback, channel selection, etc., in a different manner. The change in the device function effected by the secondary control function may be different in magnitude than the change effected by the primary control function. For example, the primary control function may effect a small change in the device function and the secondary control function may effect a large change in the device function, or vice versa, e.g., a smaller/larger volume or channel change, etc.

Conventionally, an additional function key would be needed to provide such additional control. The remote control thus needs fewer function keys to control a given number of device functions, or can control more device functions with a given number of function keys. Advantageously, the remote control enables easy and intuitive operation.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "comprise" and its conjugations does not exclude the presence of elements or steps other than those stated in a claim. The article "a" or "an" preceding an element does not exclude the presence of a plurality of such elements. The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage.

## Claims

1. An assembly (100) for providing capacitive sensing to a push button, the assembly comprising:
- a printed circuit board (120) comprising a component side (120C) and a button side (120B), the component side comprising a conductive layer for surface mounting of electronic components, the button side comprising a push detection element (140) for use in push detection of the push button (040);
- a sensor controller mounted on the component side;
- a capacitive sensor electrically connected to the sensor controller to establish the capacitive sensing in a proximity of the capacitive sensor;
wherein:
- the capacitive sensor comprises a conductive plate (160) having at least two connectors (162, 164) protruding and angling away from the conductive plate;
- the printed circuit board (120) comprises at least two through-holes (122, 124); and
- the conductive plate is arranged on the button side (120B), with the at least two connectors extending through respective ones of the at least two through-holes to the component side for establishing said electrical connection to the sensor controller.

2. The assembly (100) according to claim 1, wherein the conductive plate (160) is at least in part affixed to the printed circuit board by the at least two connectors (162, 164) being soldered to the component side (120C).

3. The assembly (100) according to claim 1, wherein the conductive plate (160) has a circular shape.

4. The assembly (100) according to claim 1, wherein the conductive plate (160) comprises a cut-out (166) for, when arranged on the button side (120B), accommodating the push detection element (140).

5. The assembly (100) according to claim 1, wherein the conductive plate (160) is a stainless steel plate or a phosphor bronze plate with silver plating.

6. The assembly (100) according to claim 1, wherein the printed circuit board (120) is a single-sided printed circuit board.

7. The assembly (100) according to claim 1, wherein the push detection element (140) comprises a carbon print.

8. A device (010) comprising a push button (040) and the assembly (100) according to claim 1.

9. The device (010) according to claim 8, wherein the device is a remote control.

10. A method (200) of manufacturing an assembly, the assembly providing capacitive sensing to a push button, the method comprising:
- providing (210) a printed circuit board comprising a component side and a button side, the component side comprising a conductive layer for surface mounting of electronic components, the button side comprising a push detection element for use in push detection of the push button, the printed circuit board comprising at least two through-holes;
- mounting (220) a sensor controller on the component side;
- providing (230) a capacitive sensor electrically connected to the sensor controller to establish the capacitive sensing in a proximity of the capacitive sensor, wherein the capacitive sensor comprises a conductive plate having at least two connectors protruding and angling away from the conductive plate; and
- arranging (240) the conductive plate on the button side, with the at least two connectors extending through respective ones of the at least two through-holes to the component side for establishing said electrical connection to the sensor controller.

11. The method (200) according to claim 10, further comprising soldering (250) the at least two connectors to the component side for at least in part affixing the conductive plate to the printed circuit board.
